# EUROPÄISCHE PATENTANMELDUNG

(11) **EP 2 112 521 A1**
(43) Veröffentlichungstag der Anmeldung: **28.10.2009**
(21) Anmeldenummer: 08155061.8
(22) Anmeldetag: 24.04.2008
(51) Int. Cl.: G01R 31/42, H02M 1/32

(54) **Verfahren zur Fehlererkennung in einer Umrichterschaltung**

(71) Anmelder: ABB Schweiz AG, 5400 Baden (CH)
(72) Erfinder: Rees, Jochen, D-79761, Waldshut-Tiengen (DE); Ruetten, Klaus, D-79761, Waldshut-Tiengen (DE)
(74) Vertreter: ABB Patent Attorneys

(57) **Zusammenfassung**

Es wird ein Verfahren zur Fehlererkennung in einer Umrichterschaltung angegeben, bei dem die Umrichterschaltung ein Teilumrichtersystem (1) und einen mit dem Teilumrichtersystem verbundenen Gleichspannungskreis (2) umfasst, wobei das Teilumrichtersystem (1) einen ersten ansteuerbaren bidirektionalen Leistungshalbleiterschalter (S1) und einen zu dem ersten ansteuerbaren bidirektionalen Leistungshalbleiterschalter (S1) in Serie geschalteten zweiten ansteuerbaren bidirektionalen Leistungshalbleiterschalter (S2) aufweist oder alternativ einen ersten, zweiten, dritten und vierten ansteuerbaren bidirektionalen Leistungshalbleiterschalter (S1,S2,S3,S4) und einen fünften und sechsten Leistungshalbleiterschalter (S5,S6) aufweist, und bei dem die ansteuerbaren bidirektionalen Leistungshalbleiterschalter (S1,S2,S3,S4) nach einer Fehlererkennungssequenz geschaltet werden. Zur Erkennung eines Fehlers des zweiten ansteuerbaren bidirektionalen Leistungshalbleiterschalters (S2) im Fall des Teilumrichtersystems (1) mit dem ersten und zweiten ansteuerbaren bidirektionalen Leistungshalbleiterschalters (S1,S2) werden nach der Fehlererkennungssequenz die ansteuerbaren bidirektionalen Leistungshalbleiterschalter (S1,S2) zunächst ausgeschaltet und der Gleichspannungskreis (2) auf ein einstellbares Spannungsniveau gebracht. Danach wird nach der Fehlererkennungssequenz der erste ansteuerbare bidirektionale Leistungshalbleiterschalter (S1) eingeschaltet, wobei das Spannungsniveau am Gleichspannungskreis (2) für eine einstellbare Zeitdauer auf einen Schwellwert hin überwacht wird.

## Beschreibung

### Technisches Gebiet

Die Erfindung bezieht sich auf das Gebiet Diagnoseverfahren von Umrichterschaltungen. Sie geht aus von einem Verfahren zur Fehlererkennung in einer Umrichterschaltung gemäss dem Oberbegriff der unabhängigen Ansprüche.

### Stand der Technik

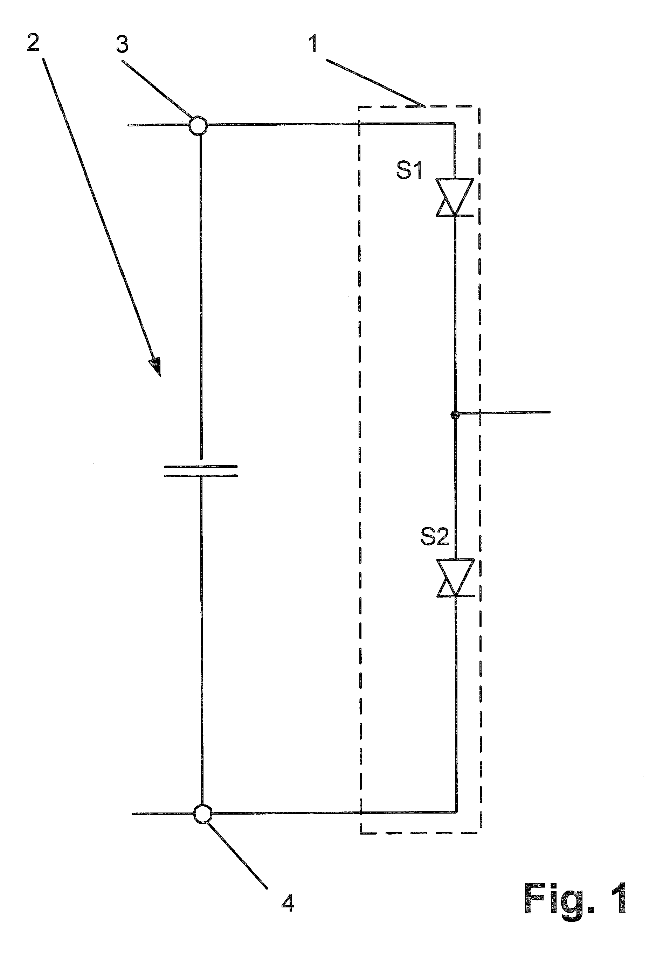

Leistungshalbleiterschalter werden derzeit vermehrt in der Umrichtertechnik und insbesondere in Umrichterschaltungen zur Schaltung von zwei oder drei Spannungsniveaus eingesetzt. Eine heute übliche Umrichterschaltung zur Schaltung von zwei Spannungsniveaus ist in Fig. 1 dargestellt. Gemäss Fig. 1 umfasst die Umrichterschaltung ein Teilumrichtersystem und einen durch einen Kondensator gebildeten Gleichspannungskreis, wobei der Gleichspannungskreis einen ersten Hauptanschluss und einen zweiten Hauptanschluss aufweist und das Teilumrichtersystem einen ersten ansteuerbaren bidirektionalen Leistungshalbleiterschalter und einen zu dem ersten ansteuerbaren bidirektionalen Leistungshalbleiterschalter in Serie geschalteten zweiten ansteuerbaren bidirektionalen Leistungshalbleiterschalter aufweist und der erste ansteuerbare bidirektionale Leistungshalbleiterschalter mit dem ersten Hauptanschluss und der zweite ansteuerbare bidirektionale Leistungshalbleiterschalter dem zweiten Hauptanschluss verbunden ist. Zur Fehlererkennung bei einem ansteuerbaren bidirektionalen Leistungshalbleiterschalter werden die ansteuerbaren bidirektionalen Leistungshalbleiterschalter typischerweise nach einer Fehlererkennungssequenz geschaltet.

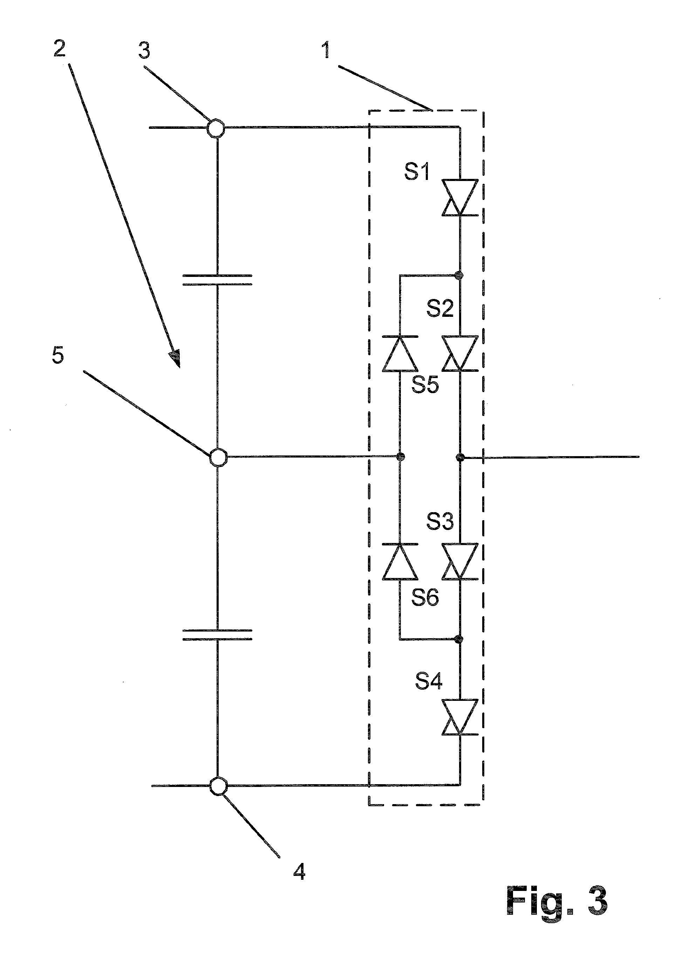

Eine weitere heute übliche Umrichterschaltung zur Schaltung von drei Spannungsniveaus ist in Fig. 3 dargestellt. Gemäss Fig. 3 umfasst die Umrichterschaltung ebenfalls ein Teilumrichtersystem und einen durch zwei in Serie geschaltete Kondensatoren gebildeten Gleichspannungskreis, wobei der Gleichspannungskreis einen ersten Hauptanschluss und einen zweiten Hauptanschluss und einen durch die zwei benachbarten und miteinander verbundenen Kondensatoren gebildeten Teilanschluss umfasst, und wobei das Teilumrichtersystem einen ersten, zweiten, dritten und vierten ansteuerbaren bidirektionalen Leistungshalbleiterschalter und einen fünften und sechsten Leistungshalbleiterschalter aufweist, wobei der erste, zweite, dritte und vierte Leistungshalbleiterschalter in Serie geschaltet sind und der erste Leistungshalbleiterschalter mit dem ersten Hauptanschluss und der vierte Leistungshalbleiterschalter mit dem zweiten Hauptanschluss verbunden ist, der fünfte und sechste Leistungshalbleiterschalter in Serie geschaltet ist, der Verbindungspunkt des fünften Leistungshalbleiterschalters mit dem sechsten Leistungshalbleiterschalter mit dem Teilanschluss verbunden ist, der fünfte Leistungshalbleiterschalter mit dem Verbindungspunkt des ersten Leistungshalbleiterschalters mit dem zweiten Leistungshalbleiterschalter verbunden ist und der sechste Leistungshalbleiterschalter mit dem Verbindungspunkt des dritten Leistungshalbleiterschalters mit dem vierten Leistungshalbleiterschalter verbunden ist. Zur Fehlererkennung bei einem ansteuerbaren bidirektionalen Leistungshalbleiterschalter und/oder bei einem Leistungshalbleiterschalter werden die ansteuerbaren bidirektionalen Leistungshalbleiterschalter ebenfalls typischerweise nach einer Fehlererkennungssequenz geschaltet. Oft sind die Verfahren zur Fehlererkennung eines oder mehrerer ansteuerbarer bidirektionaler Leistungshalbleiterschalter und/oder Leistungshalbleiterschalter kompliziert und bedingen demnach ein Schalten der ansteuerbaren bidirektionalen Leistungshalbleiterschalter nach einer komplizierten Fehlererkennungssequenz. Ein einfaches Verfahren zur Fehlererkennung eines oder mehrerer beschädigter oder fehlerhafter ansteuerbarer bidirektionaler Leistungshalbleiterschalter und/oder Leistungshalbleiterschalter wäre daher wünschenswert.

### Darstellung der Erfindung

Aufgabe der Erfindung ist es deshalb, ein Verfahren zur Fehlererkennung in einer Umrichterschaltung anzugeben, welches sehr einfach und unkompliziert ist und eine schnelle und sichere Erkennung von fehlerhaften und beschädigten ansteuerbaren bidirektionalen Leistungshalbleiterschalter der Umrichterschaltung und/oder Leistungshalbleiterschalter der Umrichterschaltung ermöglicht. Diese Aufgabe wird durch die Merkmale des Anspruchs 1 bzw. durch die Merkmale des Anspruchs 5 gelöst. In den abhängigen Ansprüchen sind vorteilhafte Weiterbildungen der Erfindung angegeben.

Beim erfindungsgemässen Verfahren zur Fehlererkennung in einer Umrichterschaltung, bei dem die Umrichterschaltung ein Teilumrichtersystem und einen durch einen Kondensator gebildeten Gleichspannungskreis umfasst, wobei der Gleichspannungskreis einen ersten Hauptanschluss und einen zweiten Hauptanschluss aufweist und das Teilumrichtersystem einen ersten ansteuerbaren bidirektionalen Leistungshalbleiterschalter und einen zu dem ersten ansteuerbaren bidirektionalen Leistungshalbleiterschalter in Serie geschalteten zweiten ansteuerbaren bidirektionalen Leistungshalbleiterschalter aufweist und der erste ansteuerbare bidirektionale Leistungshalbleiterschalter mit dem ersten Hauptanschluss und der zweite ansteuerbare bidirektionale Leistungshalbleiterschalter dem zweiten Hauptanschluss verbunden ist. Verfahrensmässig werden die ansteuerbaren bidirektionalen Leistungshalbleiterschalter dann nach einer Fehlererkennungssequenz geschaltet. Erfindungsgemäss werden nach der Fehlererkennungssequenz die ansteuerbaren bidirektionalen Leistungshalbleiterschalter zunächst ausgeschaltet und der Gleichspannungskreis auf ein einstellbares Spannungsniveau gebracht. Danach wird nach der Fehlererkennungssequenz der erste ansteuerbare bidirektionale Leistungshalbleiterschalter eingeschaltet, wobei das Spannungsniveau am Gleichspannungskreis für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete zweite ansteuerbare bidirektionalen Leistungshalbleiterschalters einen Fehler aufweist und beispielsweise leitet, obwohl dieser sperren sollte. Das Verfahren erkennt Fehler oder Beschädigungen von ansteuerbaren bidirektionalen Leistungshalbleiterschaltern der Umrichterschaltung somit schnell und sicher und zudem in denkbar einfacher und unkomplizierter Weise.

Alternativ dazu weist die Umrichterschaltung ebenfalls ein Teilumrichtersystem auf und umfasst einen durch zwei in Serie geschaltete Kondensatoren gebildeten Gleichspannungskreis, wobei der Gleichspannungskreis einen ersten Hauptanschluss und einen zweiten Hauptanschluss und einen durch die zwei benachbarten und miteinander verbundenen Kondensatoren gebildeten Teilanschluss umfasst. Das Teilumrichtersystem weist einen ersten, zweiten, dritten und vierten ansteuerbaren bidirektionalen Leistungshalbleiterschalter und einen fünften und sechsten Leistungshalbleiterschalter auf, wobei der erste, zweite, dritte und vierte Leistungshalbleiterschalter in Serie geschaltet sind und der erste Leistungshalbleiterschalter mit dem ersten Hauptanschluss und der vierte Leistungshalbleiterschalter mit dem zweiten Hauptanschluss verbunden ist, der fünfte und sechste Leistungshalbleiterschalter in Serie geschaltet ist, der Verbindungspunkt des fünften Leistungshalbleiterschalters mit dem sechsten Leistungshalbleiterschalter mit dem Teilanschluss verbunden ist, der fünfte Leistungshalbleiterschalter mit dem Verbindungspunkt des ersten Leistungshalbleiterschalters mit dem zweiten Leistungshalbleiterschalter verbunden ist und der sechste Leistungshalbleiterschalter mit dem Verbindungspunkt des dritten Leistungshalbleiterschalters mit dem vierten Leistungshalbleiterschalter verbunden ist. Auch bei dieser Alternative werden die ansteuerbaren bidirektionalen Leistungshalbleiterschalter bezüglich des erfindungsgemässen Verfahrens nach einer Fehlererkennungssequenz geschaltet. Nach der Erfindung werden nach der Fehlererkennungssequenz die ansteuerbaren bidirektionalen Leistungshalbleiterschalter zunächst ebenfalls ausgeschaltet und der Gleichspannungskreis wird auf ein einstellbares Spannungsniveau gebracht. Danach werden nach der Fehlererkennungssequenz der erste und zweite ansteuerbare bidirektionale Leistungshalbleiterschalter eingeschaltet, wobei das Spannungsniveau am Gleichspannungskreis für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete dritte ansteuerbare bidirektionale Leistungshalbleiterschalter und/oder der fünfte Leistungshalbleiterschalter einen Fehler aufweist. Auch dieses zum vorstehenden Verfahren alternative erfindungsgemässe Verfahren erkennt Fehler oder Beschädigungen von ansteuerbaren bidirektionalen Leistungshalbleiterschaltern und Leistungshalbleiterschaltern der Umrichterschaltung somit schnell und sicher und zudem in denkbar einfacher und unkomplizierter Weise.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungen

Es zeigen:
- Fig. 1: eine erste Ausführungsform einer Umrichterschaltung, insbesondere zur Schaltung von zwei Spannungsniveaus, mit einem Teilumrichtersystem,
- Fig. 2: eine zweite Ausführungsform einer Umrichterschaltung, insbesondere zur Schaltung von zwei Spannungsniveaus, mit einem Teilumrichtersystem und n weiteren Teilumrichtersystemen gemäss Fig. 1,
- Fig. 3: eine dritte Ausführungsform einer Umrichterschaltung, insbesondere zur Schaltung von drei Spannungsniveaus, mit einem Teilumrichtersystem, und
- Fig. 4: eine vierte Ausführungsform einer Umrichterschaltung, insbesondere zur Schaltung von drei Spannungsniveaus, mit einem Teilumrichtersystem und n weiteren Teilumrichtersystemen gemäss Fig. 3.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

In Fig. 1 ist die bereits eingangs detailliert beschriebene erste Ausführungsform einer herkömmlichen Umrichterschaltung, insbesondere zur Schaltung von zwei Spannungsniveaus gezeigt. Die Umrichterschaltung umfasst ein Teilumrichtersystem 1 und einen durch einen Kondensator gebildeten Gleichspannungskreis 2 umfasst, wobei der Gleichspannungskreis 2 einen ersten Hauptanschluss 3 und einen zweiten Hauptanschluss 4 aufweist. Das Teilumrichtersystem 1 weist einen ersten ansteuerbaren bidirektionalen Leistungshalbleiterschalter S1 und einen zu dem ersten ansteuerbaren bidirektionalen Leistungshalbleiterschalter S1 in Serie geschalteten zweiten ansteuerbaren bidirektionalen Leistungshalbleiterschalter S2 auf, wobei der erste ansteuerbare bidirektionale Leistungshalbleiterschalter S1 mit dem ersten Hauptanschluss 3 und der zweite ansteuerbare bidirektionale Leistungshalbleiterschalter S2 dem zweiten Hauptanschluss 4 verbunden ist. Der jeweilige ansteuerbare bidirektionale Leistungshalbleiterschalter S1, S2 ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar einen vorstehend genannten ansteuerbaren bidirektionalen Leistungshalbleiterschalter S1, S2 beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Verfahrensmässig werden die ansteuerbaren bidirektionalen Leistungshalbleiterschalter S1, S2 dann nach einer Fehlererkennungssequenz geschaltet. Erfindungsgemäss werden nach der Fehlererkennungssequenz die ansteuerbaren bidirektionalen Leistungshalbleiterschalter S1, S2 zunächst ausgeschaltet und der Gleichspannungskreis 2 auf ein einstellbares Spannungsniveau gebracht. Danach wird nach der Fehlererkennungssequenz der erste ansteuerbare bidirektionale Leistungshalbleiterschalter S1 eingeschaltet, wobei das Spannungsniveau am Gleichspannungskreis 2 für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete zweite ansteuerbare bidirektionalen Leistungshalbleiterschalters S2 einen Fehler aufweist und beispielsweise leitet, obwohl dieser sperren sollte. Das Verfahren erkennt Fehler oder Beschädigungen von ansteuerbaren bidirektionalen Leistungshalbleiterschaltern der Umrichterschaltung somit schnell und sicher und zudem in denkbar einfacher und unkomplizierter Weise.

Falls nun der Schwellwert nicht unterschritten wird, d.h. der zweite ansteuerbare bidirektionalen Leistungshalbleiterschalters S2 keinen Fehler aufweist, werden nach der Fehlererkennungssequenz die ansteuerbaren bidirektionalen Leistungshalbleiterschalter ausgeschaltet und danach wird der zweite ansteuerbare bidirektionale Leistungshalbleiterschalter S2 eingeschaltet, wobei das Spannungsniveau am Gleichspannungskreis 2 für eine einstellbare Zeitdauer auf den Schwellwert hin überwacht wird. Fällt das Spannungsniveau nun während der einstellbaren Zeitdauer unter den Schwellwert, ist dies ein Hinweis, dass der ausgeschaltete erste ansteuerbare bidirektionalen Leistungshalbleiterschalters S1 einen Fehler aufweist und beispielsweise leitet, obwohl dieser sperren sollte.

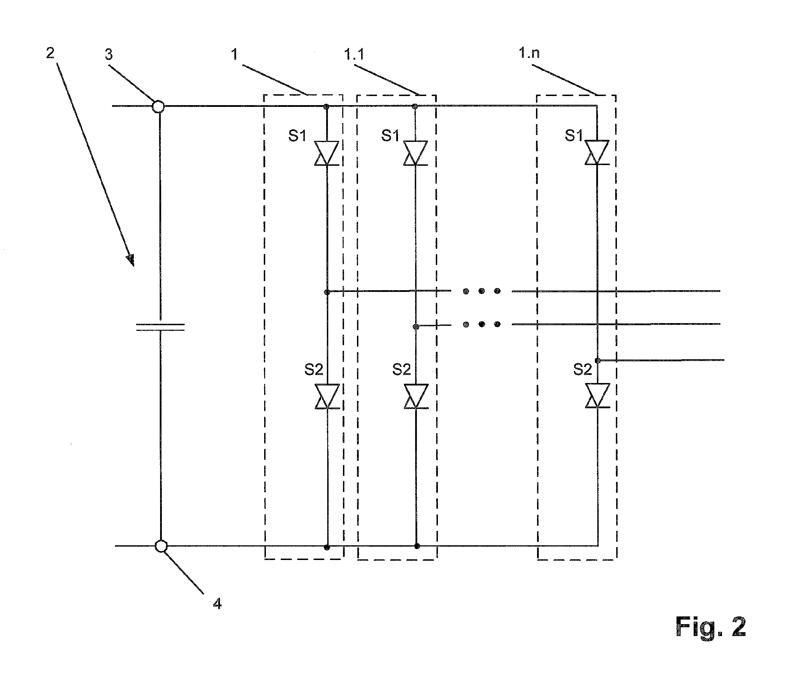

In Fig. 2 ist eine zweite Ausführungsform der Umrichterschaltung, insbesondere zur Schaltung von zwei Spannungsniveaus, dargestellt. Diese Umrichterschaltung weist neben dem Teilumrichtersystem 1 nach Fig. 1 n weiteren Teilumrichtersysteme 1.1, ... 1.n auf, wobei jedes der n weiteren Teilumrichtersysteme 1.1, ... 1.n einen ersten ansteuerbaren bidirektionalen Leistungshalbleiterschalter S1 und einen zu dem ersten ansteuerbaren bidirektionalen Leistungshalbleiterschalter S1 in Serie geschalteten zweiten ansteuerbaren bidirektionalen Leistungshalbleiterschalter S2 aufweist und der erste ansteuerbare bidirektionale Leistungshalbleiterschalter S1 mit dem ersten Hauptanschluss 3 und der zweite ansteuerbare bidirektionale Leistungshalbleiterschalter S2 dem zweiten Hauptanschluss 4 verbunden ist. Der jeweilige ansteuerbare bidirektionale Leistungshalbleiterschalter S1, S2 eines jeden der n weiteren Teilumrichtersysteme 1.1, ... 1.n ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar einen vorstehend genannten ansteuerbaren bidirektionalen Leistungshalbleiterschalter S1, S2 beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Im vorstehend bereits beschriebenen Fall, dass lediglich der erste ansteuerbare bidirektionale Leistungshalbleiterschalter S1 des Teilumrichtersystems 1 eingeschaltet und der Schwellwert nicht unterschritten wird, werden dann nach der Fehlererkennungssequenz die ansteuerbaren bidirektionalen Leistungshalbleiterschalter S1, S2 der n weiteren Teilstromrichtersysteme 1.1, ..., 1.n zunächst ausgeschaltet und danach wird zeitlich nacheinander bezüglich jedes der n weiteren Teilstromrichtersysteme 1.1, ..., 1.n der erste ansteuerbare bidirektionale Leistungshalbleiterschalter S1 des zugehörigen n weiteren Teilstromrichtersystems 1.1, ..., 1.n eingeschaltet. Nach jedem Einschalten des ersten ansteuerbaren bidirektionalen Leistungshalbleiterschalters S1 bezüglich des jeweils zugehörigen n weiteren Teilstromrichtersystems 1.1, ..., 1.n wird jeweils das Spannungsniveau am Gleichspannungskreis 2 für eine einstellbare Zeitdauer auf den Schwellwert hin überwacht. Falls dann das Spannungsniveau während der einstellbaren Zeitdauer unter den Schwellwert fällt, ist dies ein Hinweis, dass der ausgeschaltete zweite ansteuerbare bidirektionalen Leistungshalbleiterschalter S2 des jeweils zugehörigen n weiteren Teilstromrichtersystems 1.1, ..., 1.n einen Fehler aufweist. Vorzugsweise werden bei Unterschreiten des Schwellwertes die nachfolgend nacheinander noch einzuschaltenden ersten ansteuerbaren bidirektionalen Leistungshalbleiterschalter S1 der noch verbliebenen weiteren Teilstromrichtersysteme 1.1, ..., 1.n nicht mehr eingeschaltet.

Im vorstehend bereits beschriebenen Fall, dass lediglich der zweite ansteuerbare bidirektionale Leistungshalbleiterschalter S2 des Teilumrichtersystems 1 gemäss Fig. 2 eingeschaltet und der Schwellwert nicht unterschritten wird, werden dann nach der Fehlererkennungssequenz die ansteuerbaren bidirektionalen Leistungshalbleiterschalter S1, S2 der n weiteren Teilstromrichtersysteme 1.1, ..., 1.n zunächst ausgeschaltet und danach wird zeitlich nacheinander bezüglich jedes der n weiteren Teilstromrichtersysteme 1.1, ..., 1.n der zweite ansteuerbare bidirektionale Leistungshalbleiterschalter S2 des zugehörigen n weiteren Teilstromrichtersystems 1.1, ..., 1.n eingeschaltet. Nach jedem Einschalten des zweiten ansteuerbaren bidirektionalen Leistungshalbleiterschalters S2 bezüglich des jeweils zugehörigen n weiteren Teilstromrichtersystems 1.1, ..., 1.n wird jeweils das Spannungsniveau am Gleichspannungskreis 2 für eine einstellbare Zeitdauer auf den Schwellwert hin überwacht. Falls dann das Spannungsniveau während der einstellbaren Zeitdauer unter den Schwellwert fällt, ist dies ein Hinweis, dass der ausgeschaltete erste ansteuerbare bidirektionalen Leistungshalbleiterschalter S1 des jeweils zugehörigen n weiteren Teilstromrichtersystems 1.1, ..., 1.n einen Fehler aufweist. Vorzugsweise werden bei Unterschreiten des Schwellwertes die nachfolgend nacheinander noch einzuschaltenden zweiten ansteuerbaren bidirektionalen Leistungshalbleiterschalter S2 der noch verbliebenen weiteren Teilstromrichtersysteme 1.1, ..., 1.n nicht mehr eingeschaltet.

In Fig. 3 ist die alternative und bereits eingangs detailliert beschriebene dritte Ausführungsform einer herkömmlichen Umrichterschaltung, insbesondere zur Schaltung von drei Spannungsniveaus gezeigt. Die Umrichterschaltung umfasst einen durch zwei in Serie geschaltete Kondensatoren gebildeten Gleichspannungskreis 2, wobei der Gleichspannungskreis 2 einen ersten Hauptanschluss 3 und einen zweiten Hauptanschluss 4 und einen durch die zwei benachbarten und miteinander verbundenen Kondensatoren gebildeten Teilanschluss 5 aufweist. Das Teilumrichtersystem 1 weist einen ersten, zweiten, dritten und vierten ansteuerbaren bidirektionalen Leistungshalbleiterschalter S1, S2, S3, S4 und einen fünften und sechsten Leistungshalbleiterschalter S5, S6 auf, wobei der erste, zweite, dritte und vierte Leistungshalbleiterschalter S1, S2, S3, S4 in Serie geschaltet sind und der erste Leistungshalbleiterschalter S1 mit dem ersten Hauptanschluss 3 und der vierte Leistungshalbleiterschalter S4 mit dem zweiten Hauptanschluss 4 verbunden ist, der fünfte und sechste Leistungshalbleiterschalter S5, S6 in Serie geschaltet ist, der Verbindungspunkt des fünften Leistungshalbleiterschalters S5 mit dem sechsten Leistungshalbleiterschalter S6 mit dem Teilanschluss 5 verbunden ist, der fünfte Leistungshalbleiterschalter S6 mit dem Verbindungspunkt des ersten Leistungshalbleiterschalters S1 mit dem zweiten Leistungshalbleiterschalter S2 verbunden ist und der sechste Leistungshalbleiterschalter S6 mit dem Verbindungspunkt des dritten Leistungshalbleiterschalters S3 mit dem vierten Leistungshalbleiterschalter S4 verbunden ist. Der jeweilige ansteuerbare bidirektionale Leistungshalbleiterschalter S1, S2, S3, S4 ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar einen vorstehend genannten ansteuerbaren bidirektionalen Leistungshalbleiterschalter S1, S2, S3,S4 beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Der fünfte und sechste Leistungshalbleiterschalter S5, S6 ist ein nicht ansteuerbarer unidirektionaler Leistungshalbleiterschalter, jeweils gebildet durch eine Diode. Verfahrensmässig werden die ansteuerbaren bidirektionalen Leistungshalbleiterschalter S1, S2, S3, S4 dann nach einer Fehlererkennungssequenz geschaltet. Erfindungsgemäss werden nach der Fehlererkennungssequenz die ansteuerbaren bidirektionalen Leistungshalbleiterschalter S1, S2, S3, S4 zunächst ausgeschaltet und der Gleichspannungskreis 2 wird auf ein einstellbares Spannungsniveau gebracht. Danach werden nach der Fehlererkennungssequenz der erste und zweite ansteuerbare bidirektionale Leistungshalbleiterschalter S1, S2 eingeschaltet, wobei das Spannungsniveau am Gleichspannungskreis 2 für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete dritte ansteuerbare bidirektionale Leistungshalbleiterschalter S3 und/oder der fünfte Leistungshalbleiterschalter S5 einen Fehler aufweist. Auch dieses zum vorstehenden Verfahren alternative erfindungsgemässe Verfahren erkennt Fehler oder Beschädigungen von ansteuerbaren bidirektionalen Leistungshalbleiterschaltern S1, S2, S3, S4 und Leistungshalbleiterschaltern S5, S6 der Umrichterschaltung somit schnell und sicher und zudem in denkbar einfacher und unkomplizierter Weise.

Falls nun der Schwellwert nicht unterschritten wird, d.h. der dritte ansteuerbare bidirektionale Leistungshalbleiterschalter S3 und der fünfte Leistungshalbleiterschalter S5 keinen Fehler aufweist, werden nach der Fehlererkennungssequenz die ansteuerbaren bidirektionalen Leistungshalbleiterschalter S1, S2, S3, S4 ausgeschaltet und danach werden der dritte und vierte ansteuerbare bidirektionale Leistungshalbleiterschalter S3, S4 eingeschaltet, wobei das Spannungsniveau am Gleichspannungskreis 2 für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete zweite ansteuerbare bidirektionale Leistungshalbleiterschalter S2 und/oder der sechste Leistungshalbleiterschalter S6 einen Fehler aufweist.

Falls nun der Schwellwert bei den beiden vorstehend beschriebenen Fällen des Einschaltens des ersten und zweiten ansteuerbaren bidirektionalen Leistungshalbleiterschalters S1, S2 bzw. des dritten und vierten ansteuerbaren bidirektionalen Leistungshalbleiterschalters S3, S4 nicht unterschritten wird, werden nach der Fehlererkennungssequenz die ansteuerbaren bidirektionalen Leistungshalbleiterschalter S1, S2, S3, S4 ausgeschaltet und danach der zweite und dritte ansteuerbare bidirektionale Leistungshalbleiterschalter S2, S3 eingeschaltet werden, wobei das Spannungsniveau am Gleichspannungskreis 2 für eine einstellbare Zeitdauer auf einen Schwellwert hin überwacht wird. Fällt das Spannungsniveau nun während der einstellbaren Zeitdauer unter den Schwellwert, ist dies ein Hinweis, dass der ausgeschaltete erste ansteuerbare bidirektionale Leistungshalbleiterschalter S1 und/oder der ausgeschaltete vierte ansteuerbare bidirektionale Leistungshalbleiterschalter S4 einen Fehler aufweist. Wird das Spannungsniveau am Gleichspannungskreis 2 separat an jedem Kondensator überwacht und fällt das Spannungsniveau nun während der einstellbaren Zeitdauer unter den Schwellwert an dem mit dem ersten ansteuerbaren bidirektionalen Leistungshalbleiterschalter S1 verbundenen Kondensator, dann ist dies ein Hinweis, dass der ausgeschaltete erste ansteuerbare bidirektionale Leistungshalbleiterschalter S1 einen Fehler aufweist. Fällt das Spannungsniveau während der einstellbaren Zeitdauer unter den Schwellwert hingegen an dem mit dem zweiten ansteuerbaren bidirektionalen Leistungshalbleiterschalter S2 verbundenen Kondensator, dann ist dies ein Hinweis, dass der ausgeschaltete zweite ansteuerbare bidirektionale Leistungshalbleiterschalter S1 einen Fehler aufweist.

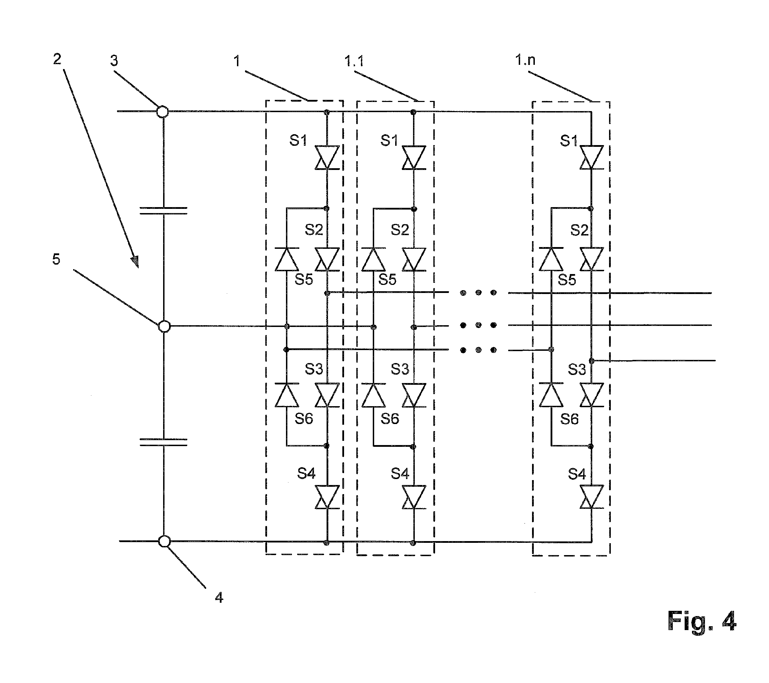

In Fig. 4 ist eine vierte Ausführungsform der Umrichterschaltung, insbesondere zur Schaltung von drei Spannungsniveaus, dargestellt. Diese Umrichterschaltung weist neben dem Teilumrichtersystem 1 nach Fig. 3 n weiteren Teilumrichtersysteme 1.1, ... 1.n auf, wobei jedes der n weiteren Teilumrichtersysteme 1 einen ersten, zweiten, dritten und vierten ansteuerbaren bidirektionalen Leistungshalbleiterschalter S1, S2, S3, S4 und einen fünften und sechsten Leistungshalbleiterschalter S5, S6 aufweist und der erste, zweite, dritte und vierte Leistungshalbleiterschalter S1, S2, S3, S4 in Serie geschaltet sind und der erste Leistungshalbleiterschalter S1 mit dem ersten Hauptanschluss 3 und der vierte Leistungshalbleiterschalter S4 mit dem zweiten Hauptanschluss 4 verbunden ist, der fünfte und sechste Leistungshalbleiterschalter S5, S6 in Serie geschaltet ist, der Verbindungspunkt des fünften Leistungshalbleiterschalters S5 mit dem sechsten Leistungshalbleiterschalter S6 mit dem Teilanschluss 5 verbunden ist, der fünfte Leistungshalbleiterschalter S6 mit dem Verbindungspunkt des ersten Leistungshalbleiterschalters S1 mit dem zweiten Leistungshalbleiterschalter S2 verbunden ist und der sechste Leistungshalbleiterschalter S6 mit dem Verbindungspunkt des dritten Leistungshalbleiterschalters S3 mit dem vierten Leistungshalbleiterschalter S4 verbunden ist. Der jeweilige ansteuerbare bidirektionale Leistungshalbleiterschalter S1, S2, S3, S4 eines jeden der n weiteren Teilumrichtersysteme 1.1, ... 1.n ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar einen vorstehend genannten ansteuerbaren bidirektionalen Leistungshalbleiterschalter S1, S2, S3,S4 beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Der jeweilige fünfte und sechste Leistungshalbleiterschalter S5, S6 eines jeden der n weiteren Teilumrichtersysteme 1.1, ... 1.n ist ein nicht ansteuerbarer unidirektionaler Leistungshalbleiterschalter, jeweils gebildet durch eine Diode. Falls nun der Schwellwert bei dem vorstehend beschriebenen Fall des Einschaltens des ersten und zweiten ansteuerbaren bidirektionalen Leistungshalbleiterschalters S1, S2 des Teilumrichtersystems 1 gemäss Fig. 4 nicht unterschritten wird, werden nach der Fehlererkennungssequenz die ansteuerbaren bidirektionalen Leistungshalbleiterschalter S1, S2, S3, S4 der n weiteren Teilstromrichtersysteme 1.1, ..., 1.n ausgeschaltet und danach werden zeitlich nacheinander bezüglich jedes der n weiteren Teilstromrichtersysteme 1.1, ..., 1.n der erste und zweite ansteuerbare bidirektionale Leistungshalbleiterschalter S1, S2 des zugehörigen n weiteren Teilstromrichtersystems 1.1, ..., 1.n eingeschaltet. Nach jedem Einschalten des ersten und zweiten ansteuerbaren bidirektionalen Leistungshalbleiterschalters S1, S2 des jeweils zugehörigen n weiteren Teilstromrichtersystems 1.1, ..., 1.n wird jeweils das Spannungsniveau am Gleichspannungskreis 2 für eine einstellbare Zeitdauer auf den Schwellwert hin überwacht. Falls dann das Spannungsniveau während der einstellbaren Zeitdauer unter den Schwellwert fällt, ist dies ein Hinweis, dass der ausgeschaltete dritte ansteuerbare bidirektionale Leistungshalbleiterschalter S3 und/oder der fünfte Leistungshalbleiterschalter S5 des jeweils zugehörigen n weiteren Teilstromrichtersystems 1.1, ..., 1.n einen Fehler aufweist. Vorzugsweise werden bei Unterschreiten des Schwellwertes die nachfolgend nacheinander noch einzuschaltenden ersten und zweiten ansteuerbaren bidirektionalen Leistungshalbleiterschalter S1, S2 der noch verbliebenen weiteren Teilstromrichtersysteme 1.1, ..., 1.n nicht mehr eingeschaltet.

Falls nun der Schwellwert bei dem vorstehend beschriebenen Fall des Einschaltens des dritten und vierten ansteuerbaren bidirektionalen Leistungshalbleiterschalters S3, S4 des Teilumrichtersystems 1 gemäss Fig. 4 nicht unterschritten wird, werden nach der Fehlererkennungssequenz die ansteuerbaren bidirektionalen Leistungshalbleiterschalter S1, S2, S3, S4 der n weiteren Teilstromrichtersysteme 1.1, ..., 1.n ausgeschaltet und danach werden zeitlich nacheinander bezüglich jedes der n weiteren Teilstromrichtersysteme 1.1, ..., 1.n der dritte und vierte ansteuerbare bidirektionale Leistungshalbleiterschalter S3, S4 des zugehörigen n weiteren Teilstromrichtersystems 1.1, ..., 1.n eingeschaltet. Nach jedem Einschalten des dritten und vierten ansteuerbaren bidirektionalen Leistungshalbleiterschalters S3, S4 des jeweils zugehörigen n weiteren Teilstromrichtersystems 1.1, ..., 1.n wird jeweils das Spannungsniveau am Gleichspannungskreis 2 für eine einstellbare Zeitdauer auf den Schwellwert hin überwacht. Falls dann das Spannungsniveau während der einstellbaren Zeitdauer unter den Schwellwert fällt, ist dies ein Hinweis, dass der ausgeschaltete zweite ansteuerbare bidirektionale Leistungshalbleiterschalter S2 und/oder der sechste Leistungshalbleiterschalter S6 des jeweils zugehörigen n weiteren Teilstromrichtersystems 1.1, ..., 1.n einen Fehler aufweist. Vorzugsweise werden bei Unterschreiten des Schwellwertes die nachfolgend nacheinander noch einzuschaltenden dritten und vierten ansteuerbaren bidirektionalen Leistungshalbleiterschalter S3, S4 der noch verbliebenen weiteren Teilstromrichtersysteme 1.1, ..., 1.n nicht mehr eingeschaltet.

Falls nun der Schwellwert bei dem vorstehend beschriebenen Fall des Einschaltens des zweiten und dritten ansteuerbaren bidirektionalen Leistungshalbleiterschalters S2, S3 des Teilumrichtersystems 1 gemäss Fig. 4 nicht unterschritten wird, werden nach der Fehlererkennungssequenz die ansteuerbaren bidirektionalen Leistungshalbleiterschalter S1, S2, S3, S4 der n weiteren Teilstromrichtersysteme 1.1, ..., 1.n ausgeschaltet und danach werden zeitlich nacheinander bezüglich jedes der n weiteren Teilstromrichtersysteme 1.1, ..., 1.n der zweite und dritte ansteuerbare bidirektionale Leistungshalbleiterschalter S2, S3 des zugehörigen n weiteren Teilstromrichtersystems 1.1, ..., 1.n eingeschaltet. Nach jedem Einschalten des zweiten und dritten ansteuerbaren bidirektionalen Leistungshalbleiterschalters S2, S3 des jeweils zugehörigen n weiteren Teilstromrichtersystems 1.1, ..., 1.n wird jeweils das Spannungsniveau am Gleichspannungskreis 2 für eine einstellbare Zeitdauer auf den Schwellwert hin überwacht. Falls dann das Spannungsniveau während der einstellbaren Zeitdauer unter den Schwellwert fällt, ist dies ein Hinweis, dass der ausgeschaltete erste ansteuerbare bidirektionale Leistungshalbleiterschalter S1 und/oder der ausgeschaltete vierte ansteuerbare bidirektionale Leistungshalbleiterschalter S4 des jeweils zugehörigen n weiteren Teilstromrichtersystems 1.1, ..., 1.n einen Fehler aufweist. Wird das Spannungsniveau am Gleichspannungskreis 2 separat an jedem Kondensator überwacht und fällt das Spannungsniveau nun während der einstellbaren Zeitdauer unter den Schwellwert an dem mit dem jeweiligen ersten ansteuerbaren bidirektionalen Leistungshalbleiterschalter S1 verbundenen Kondensator, dann ist dies ein Hinweis, dass der ausgeschaltete erste ansteuerbare bidirektionale Leistungshalbleiterschalter S1 des jeweils zugehörigen n weiteren Teilstromrichtersystems 1.1, ..., 1.n einen Fehler aufweist. Fällt das Spannungsniveau während der einstellbaren Zeitdauer unter den Schwellwert hingegen an dem mit dem jeweiligen zweiten ansteuerbaren bidirektionalen Leistungshalbleiterschalter S2 verbundenen Kondensator, dann ist dies ein Hinweis, dass der ausgeschaltete zweite ansteuerbare bidirektionale Leistungshalbleiterschalter S1 des jeweils zugehörigen n weiteren Teilstromrichtersystems 1.1, ..., 1.n einen Fehler aufweist. Vorzugsweise werden bei Unterschreiten des Schwellwertes die nachfolgend nacheinander noch einzuschaltenden zweiten und dritten ansteuerbaren bidirektionalen Leistungshalbleiterschalter S2, S3 der noch verbliebenen weiteren Teilstromrichtersysteme 1.1, ..., 1.n nicht mehr eingeschaltet.

Es hat sich als vorteilhaft erwiesen, dass die einstellbare Zeitdauer in der Grössenordnung 50ms gewählt wird. Dadurch kann das erfindungsgemässe Verfahren vorteilhaft beispielsweise vor oder nach Aufnahme des normalen Betriebes der Umrichterschaltung durchgeführt werden, ohne dass viel Zeitverlust entsteht.

### Bezugszeichenliste

- 1: Teilumrichtersystem
- 2: Gleichspannungskreis
- 3: erster Hauptanschluss
- 4: zweiter Hauptanschluss
- 5: Teilanschluss
- S1: erste Leistungshalbleiterschalter
- S2: zweiter Leistungshalbleiterschalter
- S3: dritter Leistungshalbleiterschalter
- S4: vierter Leistungshalbleiterschalter
- S5: fünfter Leistungshalbleiterschalter
- S6: sechster Leistungshalbleiterschalter

## Patentansprüche

1. Verfahren zur Fehlererkennung in einer Umrichterschaltung, bei dem die Umrichterschaltung ein Teilumrichtersystem (1) und einen durch einen Kondensator gebildeten Gleichspannungskreis (2) umfasst, wobei der Gleichspannungskreis (2) einen ersten Hauptanschluss (3) und einen zweiten Hauptanschluss (4) aufweist und das Teilumrichtersystem (1) einen ersten ansteuerbaren bidirektionalen Leistungshalbleiterschalter (S1) und einen zu dem ersten ansteuerbaren bidirektionalen Leistungshalbleiterschalter (S1) in Serie geschalteten zweiten ansteuerbaren bidirektionalen Leistungshalbleiterschalter (S2) aufweist und der erste ansteuerbare bidirektionale Leistungshalbleiterschalter (S1) mit dem ersten Hauptanschluss (3) und der zweite ansteuerbare bidirektionale Leistungshalbleiterschalter (S2) dem zweiten Hauptanschluss (4) verbunden ist, bei dem die ansteuerbaren bidirektionalen Leistungshalbleiterschalter (S1, S2) nach einer Fehlererkennungssequenz geschaltet werden,
**dadurch gekennzeichnet,**
**dass** nach der Fehlererkennungssequenz die ansteuerbaren bidirektionalen Leistungshalbleiterschalter (S1, S2) ausgeschaltet werden
**dass** der Gleichspannungskreis (2) auf ein einstellbares Spannungsniveau gebracht wird,
und nach der Fehlererkennungssequenz der erste ansteuerbare bidirektionale Leistungshalbleiterschalter (S1) eingeschaltet wird, wobei das Spannungsniveau am Gleichspannungskreis (2) für eine einstellbare Zeitdauer auf einen Schwellwert hin überwacht wird.

2. Verfahren nach Anspruch 1, **dadurch gekennzeichnet, dass** falls der Schwellwert nicht unterschritten wird nach der Fehlererkennungssequenz die ansteuerbaren bidirektionalen Leistungshalbleiterschalter (S1, S2) ausgeschaltet werden und danach der zweite ansteuerbare bidirektionale Leistungshalbleiterschalter (S2) eingeschaltet wird, wobei das Spannungsniveau am Gleichspannungskreis (2) für eine einstellbare Zeitdauer auf den Schwellwert hin überwacht wird.

3. Verfahren nach Anspruch 1, **dadurch gekennzeichnet, dass** n weitere Teilumrichtersysteme (1.1, ..., 1.n) vorgesehen sind, wobei jedes der n weiteren Teilumrichtersysteme (1) einen ersten ansteuerbaren bidirektionalen Leistungshalbleiterschalter (S1) und einen zu dem ersten ansteuerbaren bidirektionalen Leistungshalbleiterschalter (S1) in Serie geschalteten zweiten ansteuerbaren bidirektionalen Leistungshalbleiterschalter (S2) aufweist und der erste ansteuerbare bidirektionale Leistungshalbleiterschalter (S1) mit dem ersten Hauptanschluss (3) und der zweite ansteuerbare bidirektionale Leistungshalbleiterschalter (S2) dem zweiten Hauptanschluss (4) verbunden ist, dass falls der Schwellwert nicht unterschritten wird nach der Fehlererkennungssequenz die ansteuerbaren bidirektionalen Leistungshalbleiterschalter (S1, S2) der n weiteren Teilstromrichtersysteme (1.1, ..., 1.n) ausgeschaltet werden und danach zeitlich nacheinander bezüglich jedes der n weiteren Teilstromrichtersysteme (1.1, ..., 1.n) der erste ansteuerbare bidirektionale Leistungshalbleiterschalter (S1) des zugehörigen n weiteren Teilstromrichtersystems (1.1, ..., 1.n) eingeschaltet wird, wobei jeweils das Spannungsniveau am Gleichspannungskreis (2) für eine einstellbare Zeitdauer auf den Schwellwert hin überwacht wird.

4. Verfahren nach Anspruch 2, **dadurch gekennzeichnet, dass** n weitere Teilumrichtersysteme (1.1, ..., 1.n) vorgesehen sind, wobei jedes der n weiteren Teilumrichtersysteme (1) einen ersten ansteuerbaren bidirektionalen Leistungshalbleiterschalter (S1) und einen zu dem ersten ansteuerbaren bidirektionalen Leistungshalbleiterschalter (S1) in Serie geschalteten zweiten ansteuerbaren bidirektionalen Leistungshalbleiterschalter (S2) aufweist und der erste ansteuerbare bidirektionale Leistungshalbleiterschalter (S1) mit dem ersten Hauptanschluss (3) und der zweite ansteuerbare bidirektionale Leistungshalbleiterschalter (S2) dem zweiten Hauptanschluss (4) verbunden ist, dass falls der Schwellwert nicht unterschritten wird nach der Fehlererkennungssequenz die ansteuerbaren bidirektionalen Leistungshalbleiterschalter (S1, S2) der n weiteren Teilstromrichtersysteme (1.1, ..., 1.n) ausgeschaltet werden und danach zeitlich nacheinander der jeweilige zweite ansteuerbare bidirektionale Leistungshalbleiterschalter (S2) des zugehörigen n weiteren Teilstromrichtersystems (1.1, ..., 1.n) eingeschaltet wird, wobei jeweils das Spannungsniveau am Gleichspannungskreis (2) für eine einstellbare Zeitdauer auf den Schwellwert hin überwacht wird.

5. Verfahren zur Fehlererkennung in einer Umrichterschaltung, bei dem die Umrichterschaltung ein Teilumrichtersystem (1) aufweist und einen durch zwei in Serie geschaltete Kondensatoren gebildeten Gleichspannungskreis (2) umfasst, wobei der Gleichspannungskreis (2) einen ersten Hauptanschluss (3) und einen zweiten Hauptanschluss (4) und einen durch die zwei benachbarten und miteinander verbundenen Kondensatoren gebildeten Teilanschluss (5) umfasst, und wobei das Teilumrichtersystem (1) einen ersten, zweiten, dritten und vierten ansteuerbaren bidirektionalen Leistungshalbleiterschalter (S1, S2, S3, S4) und einen fünften und sechsten Leistungshalbleiterschalter (S5, S6) aufweist, wobei der erste, zweite, dritte und vierte Leistungshalbleiterschalter (S1, S2, S3, S4) in Serie geschaltet sind und der erste Leistungshalbleiterschalter (S1) mit dem ersten Hauptanschluss (3) und der vierte Leistungshalbleiterschalter (S4) mit dem zweiten Hauptanschluss (4) verbunden ist, der fünfte und sechste Leistungshalbleiterschalter (S5, S6) in Serie geschaltet ist, der Verbindungspunkt des fünften Leistungshalbleiterschalters (S5) mit dem sechsten Leistungshalbleiterschalter (S6) mit dem Teilanschluss (5) verbunden ist, der fünfte Leistungshalbleiterschalter (S6) mit dem Verbindungspunkt des ersten Leistungshalbleiterschalters (S1) mit dem zweiten Leistungshalbleiterschalter (S2) verbunden ist und der sechste Leistungshalbleiterschalter (S6) mit dem Verbindungspunkt des dritten Leistungshalbleiterschalters (S3) mit dem vierten Leistungshalbleiterschalter (S4) verbunden ist,
bei dem die ansteuerbaren bidirektionalen Leistungshalbleiterschalter (S1, S2, S3, S4) nach einer Fehlererkennungssequenz geschaltet werden,
**dadurch gekennzeichnet,**
**dass** nach der Fehlererkennungssequenz die ansteuerbaren bidirektionalen Leistungshalbleiterschalter (S1, S2, S3, S4) ausgeschaltet werden,
**dass** der Gleichspannungskreis (2) auf ein einstellbares Spannungsniveau gebracht wird,
und nach der Fehlererkennungssequenz der erste und zweite ansteuerbare bidirektionale Leistungshalbleiterschalter (S1, S2) eingeschaltet werden, wobei das Spannungsniveau am Gleichspannungskreis (2) für eine einstellbare Zeitdauer auf einen Schwellwert hin überwacht wird.

6. Verfahren nach Anspruch 5, **dadurch gekennzeichnet, dass** falls der Schwellwert nicht unterschritten wird nach der Fehlererkennungssequenz die ansteuerbaren bidirektionalen Leistungshalbleiterschalter (S1, S2, S3, S4) ausgeschaltet werden und danach der dritte und vierte ansteuerbare bidirektionale Leistungshalbleiterschalter (S3, S4) eingeschaltet werden, wobei das Spannungsniveau am Gleichspannungskreis (2) für eine einstellbare Zeitdauer auf einen Schwellwert hin überwacht wird.

7. Verfahren nach Anspruch 5 oder 6, **dadurch gekennzeichnet, dass** falls der Schwellwert nicht unterschritten wird nach der Fehlererkennungssequenz die ansteuerbaren bidirektionalen Leistungshalbleiterschalter (S1, S2, S3, S4) ausgeschaltet werden und danach der zweite und dritte ansteuerbare bidirektionale Leistungshalbleiterschalter (S2, S3) eingeschaltet werden, wobei das Spannungsniveau am Gleichspannungskreis (2) für eine einstellbare Zeitdauer auf einen Schwellwert hin überwacht wird.

8. Verfahren nach Anspruch 5, **dadurch gekennzeichnet, dass** n weitere Teilumrichtersysteme (1.1, ..., 1.n) vorgesehen sind, wobei jedes der n weiteren Teilumrichtersysteme (1) einen ersten, zweiten, dritten und vierten ansteuerbaren bidirektionalen Leistungshalbleiterschalter (S1, S2, S3, S4) und einen fünften und sechsten Leistungshalbleiterschalter (S5, S6) aufweist und wobei der erste, zweite, dritte und vierte Leistungshalbleiterschalter (S1, S2, S3, S4) in Serie geschaltet sind und der erste Leistungshalbleiterschalter (S1) mit dem ersten Hauptanschluss (3) und der vierte Leistungshalbleiterschalter (S4) mit dem zweiten Hauptanschluss (4) verbunden ist, der fünfte und sechste Leistungshalbleiterschalter (S5, S6) in Serie geschaltet ist, der Verbindungspunkt des fünften Leistungshalbleiterschalters (S5) mit dem sechsten Leistungshalbleiterschalter (S6) mit dem Teilanschluss (5) verbunden ist, der fünfte Leistungshalbleiterschalter (S6) mit dem Verbindungspunkt des ersten Leistungshalbleiterschalters (S1) mit dem zweiten Leistungshalbleiterschalter (S2) verbunden ist und der sechste Leistungshalbleiterschalter (S6) mit dem Verbindungspunkt des dritten Leistungshalbleiterschalters (S3) mit dem vierten Leistungshalbleiterschalter (S4) verbunden ist, dass falls der Schwellwert nicht unterschritten wird nach der Fehlererkennungssequenz die ansteuerbaren bidirektionalen Leistungshalbleiterschalter (S1, S2, S3, S4) der n weiteren Teilstromrichtersysteme (1.1, ..., 1.n) ausgeschaltet werden und danach zeitlich nacheinander bezüglich jedes der n weiteren Teilstromrichtersysteme (1.1, ..., 1.n) der erste und zweite ansteuerbare bidirektionale Leistungshalbleiterschalter (S1, S2) des zugehörigen n weiteren Teilstromrichtersystems (1.1, ..., 1.n) eingeschaltet wird, wobei jeweils das Spannungsniveau am Gleichspannungskreis (2) für eine einstellbare Zeitdauer auf den Schwellwert hin überwacht wird.

9. Verfahren nach Anspruch 6, **dadurch gekennzeichnet, dass** n weitere Teilumrichtersysteme (1.1, ..., 1.n) vorgesehen sind, wobei jedes der n weiteren Teilumrichtersysteme (1) einen ersten, zweiten, dritten und vierten ansteuerbaren bidirektionalen Leistungshalbleiterschalter (S1, S2, S3, S4) und einen fünften und sechsten Leistungshalbleiterschalter (S5, S6) aufweist und wobei der erste, zweite, dritte und vierte Leistungshalbleiterschalter (S1, S2, S3, S4) in Serie geschaltet sind und der erste Leistungshalbleiterschalter (S1) mit dem ersten Hauptanschluss (3) und der vierte Leistungshalbleiterschalter (S4) mit dem zweiten Hauptanschluss (4) verbunden ist, der fünfte und sechste Leistungshalbleiterschalter (S5, S6) in Serie geschaltet ist, der Verbindungspunkt des fünften Leistungshalbleiterschalters (S5) mit dem sechsten Leistungshalbleiterschalter (S6) mit dem Teilanschluss (5) verbunden ist, der fünfte Leistungshalbleiterschalter (S6) mit dem Verbindungspunkt des ersten Leistungshalbleiterschalters (S1) mit dem zweiten Leistungshalbleiterschalter (S2) verbunden ist und der sechste Leistungshalbleiterschalter (S6) mit dem Verbindungspunkt des dritten Leistungshalbleiterschalters (S3) mit dem vierten Leistungshalbleiterschalter (S4) verbunden ist, dass falls der Schwellwert nicht unterschritten wird nach der Fehlererkennungssequenz die ansteuerbaren bidirektionalen Leistungshalbleiterschalter (S1, S2, S3, S4) der n weiteren Teilstromrichtersysteme (1.1, ..., 1.n) ausgeschaltet werden und danach zeitlich nacheinander bezüglich jedes der n weiteren Teilstromrichtersysteme (1.1, ..., 1.n) der dritte und vierte ansteuerbare bidirektionale Leistungshalbleiterschalter (S3, S4) des zugehörigen n weiteren Teilstromrichtersystems (1.1, ..., 1.n) eingeschaltet wird, wobei jeweils das Spannungsniveau am Gleichspannungskreis (2) für eine einstellbare Zeitdauer auf den Schwellwert hin überwacht wird.

10. Verfahren nach Anspruch 7, **dadurch gekennzeichnet, dass** n weitere Teilumrichtersysteme (1.1, ..., 1.n) vorgesehen sind, wobei jedes der n weiteren Teilumrichtersysteme (1) einen ersten, zweiten, dritten und vierten ansteuerbaren bidirektionalen Leistungshalbleiterschalter (S1, S2, S3, S4) und einen fünften und sechsten Leistungshalbleiterschalter (S5, S6) aufweist und wobei der erste, zweite, dritte und vierte Leistungshalbleiterschalter (S1, S2, S3, S4) in Serie geschaltet sind und der erste Leistungshalbleiterschalter (S1) mit dem ersten Hauptanschluss (3) und der vierte Leistungshalbleiterschalter (S4) mit dem zweiten Hauptanschluss (4) verbunden ist, der fünfte und sechste Leistungshalbleiterschalter (S5, S6) in Serie geschaltet ist, der Verbindungspunkt des fünften Leistungshalbleiterschalters (S5) mit dem sechsten Leistungshalbleiterschalter (S6) mit dem Teilanschluss (5) verbunden ist, der fünfte Leistungshalbleiterschalter (S6) mit dem Verbindungspunkt des ersten Leistungshalbleiterschalters (S1) mit dem zweiten Leistungshalbleiterschalter (S2) verbunden ist und der sechste Leistungshalbleiterschalter (S6) mit dem Verbindungspunkt des dritten Leistungshalbleiterschalters (S3) mit dem vierten Leistungshalbleiterschalter (S4) verbunden ist, dass falls der Schwellwert nicht unterschritten wird nach der Fehlererkennungssequenz die ansteuerbaren bidirektionalen Leistungshalbleiterschalter (S1, S2, S3, S4) der n weiteren Teilstromrichtersysteme (1.1, ..., 1.n) ausgeschaltet werden und danach zeitlich nacheinander bezüglich jedes der n weiteren Teilstromrichtersysteme (1.1, ..., 1.n) der zweite und dritte ansteuerbare bidirektionale Leistungshalbleiterschalter (S2, S3) des zugehörigen n weiteren Teilstromrichtersystems (1.1, ..., 1.n) eingeschaltet wird, wobei jeweils das Spannungsniveau am Gleichspannungskreis (2) für eine einstellbare Zeitdauer auf den Schwellwert hin überwacht wird.

11. Verfahren nach einem der vorhergehenden Ansprüche, **dadurch gekennzeichnet, dass** die einstellbare Zeitdauer in der Grössenordnung 50ms gewählt wird.
